(19) **Europäisches Patentamt**
**European Patent Office**
**Office européen des brevets**

(11) **EP 1 887 061 A2**

(12) **EUROPEAN PATENT APPLICATION**

(43) Date of publication:
**13.02.2008 Bulletin 2008/07**

(51) Int Cl.:
*C09J 7/02* (2006.01)    *B32B 27/32* (2006.01)

(21) Application number: **07015733.4**

(22) Date of filing: **09.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **10.08.2006 JP 2006218681**

(71) Applicant: **NITTO DENKO CORPORATION Osaka (JP)**

(72) Inventor: **Shintani, Toshio Ibaraki-shi Osaka (JP)**

(74) Representative: **Grünecker, Kinkeldey, Stockmair & Schwanhäusser Anwaltssozietät Maximilianstrasse 58 80538 München (DE)**

(54) **Pressure-sensitive adhesive sheets for wafer grinding**

(57)    The present invention relates to a pressure-sensitive adhesive sheet for semiconductor wafer processing, which includes a substrate and a pressure-sensitive adhesive layer disposed on the substrate, the pressure-sensitive adhesive sheet or said substrate having a thermal shrinkage ratio of 2% or lower after having been allowed to stand at 60°C for 10 minutes. This pressure-sensitive adhesive sheet preferably has a degree of elongation of 2% or lower in a silicon wafer application test of the pressure-sensitive adhesive sheet. According to this pressure-sensitive adhesive sheet, the back side of a semiconductor wafer can be ground to an extremely small thickness without bending the wafer.

**Description**

**FIELD OF THE INVENTION**

The present invention relates to pressure-sensitive adhesive sheets for semiconductor wafer processing. More particularly, the invention relates to pressure-sensitive adhesive sheets for semiconductor wafer processing which are suitable for use in grinding a semiconductor wafer to an extremely small thickness.

**BACKGROUND OF THE INVENTION**

Various packages and IC cards are spreading in recent years, and electronic parts including semiconductor wafers are desired to be further reduced in thickness. It has hence become necessary to reduce the thickness of semiconductor chips, which has been about 350 $\mu$m, to 75-150 $\mu$m or below. Furthermore, the use of even larger wafers is being investigated in order to improve productivity.

In semiconductor wafer production, a technique in which the back side of a wafer is ground after circuit pattern formation has been employed. In this processing, a pressure-sensitive adhesive sheet is applied to the circuit surface to protect the circuit surface and fix the wafer and the back side of this wafer is then ground. Conventionally, pressure-sensitive adhesive sheets obtained by coating a flexible substrate made of an ethylene/vinyl acetate copolymer, polyethylene, or the like with a pressure-sensitive adhesive have been used in this application. However, there has been the following problem. When a pressure-sensitive adhesive sheet employing such a specific flexible substrate is used, the tensile force applied during the application thereof accumulates as a residual stress. Furthermore, the pressure-sensitive adhesive sheet, or mainly the substrate, thermally shrinks due to the heat generated in the wafer back-side grinding step and in the succeeding processing step called dry polishing or CMP and this shrinkage generates an internal stress. In the case where a wafer having a large diameter is ground to an extremely small thickness, the residual stress and stress generated in the pressure-sensitive adhesive sheet become higher than the strength of the wafer, and a force which eliminates the residual stress causes the wafer to warp (bend).

Therefore, investigations are being made on the use of a rigid substrate as the substrate of a pressure-sensitive adhesive sheet for the protection of ultrathin wafers or large-diameter waters. However, a pressure-sensitive adhesive sheet employing a rigid substrate has a drawback that when this adhesive sheet is stripped from a wafer, the force applied for the stripping is transferred to the wafer because of the rigidity of the substrate and this may break the wafer which has become brittle as a result of grinding to an extremely small thickness. In addition, use of the pressure-sensitive adhesive sheet employing a rigid substrate is apt to enhance cutter wear in tape cutting during tape application and, hence, it is difficult to maintain cutting quality. As a result, there is a problem that wafer breakage is apt to occur in grinding semiconductor wafer to an extremely small thickness.

In JP-A-2000-150432, a pressure-sensitive adhesive sheet which, in a tensile test, has a stress relaxation ratio at 10% elongation of 40% or higher after 1 minute has been proposed as a pressure-sensitive adhesive sheet which eliminates those problems and is suitable for the grinding of a semiconductor wafer to an extremely small thickness. However, this pressure-sensitive adhesive sheet has a drawback that the step of producing a material for constituting the substrate and the step of producing the substrate film are complicated and, as a result, the completed pressure-sensitive adhesive sheet is highly expensive. In addition, although this pressure-sensitive adhesive sheet has excellent properties when used as a pressure-sensitive adhesive sheet for the back-side grinding of a semiconductor wafer having a large diameter, the properties are not always optimal.

**SUMMARY OF THE INVENTION**

An object of the invention is to provide, at low cost through simple production steps, a pressure-sensitive adhesive sheet for semiconductor wafer processing which can hold a large-diameter wafer and enables it to be ground even to an extremely small thickness without bending the wafer in the step of semiconductor wafer back-side polishing and a post-processing step.

The present inventors have made intensive investigations in order to overcome the problems described above. As a result, they found that the occurrence of wafer bending in the step of semiconductor wafer back-side grinding is considerably related to four properties of the pressure-sensitive adhesive sheet for semiconductor wafer process, i.e., thermal shrinkage ratio, stress in sheet elongation, stress relaxation ratio, and degree of elongation in application to the adherend. Furthermore, they found that wafer bending can be inhibited by regulating at least one of these properties so as to be in a proper range. The invention has been thus completed.

**DETAILED DESCRIPTION OF THE INVENTION**

The invention provides a pressure-sensitive adhesive sheet for semiconductor wafer processing, which comprises a substrate and a pressure-sensitive adhesive layer disposed on the substrate, the pressure-sensitive adhesive sheet or the substrate having a thermal shrinkage ratio of 2% or lower after having been allowed to stand at 60°C for 10 minutes. This pressure-sensitive adhesive sheet desirably has a degree of elongation of 2% or lower in a silicon wafer application test of the pressure-sensitive adhesive sheet.

The invention further provides a pressure-sensitive adhesive sheet for semiconductor wafer processing, which comprises a substrate and a pressure-sensitive adhesive layer disposed on the substrate, the pressure-sensitive adhesive sheet having a stress relaxation ratio at 2% elongation of 20% or higher at 1 minute after initiation of the elongated state in a tensile test. This pressure-sensitive adhesive sheet desirably has a stress relaxation ratio at 2% elongation of 25% or higher at 10 minutes after initiation of the elongated state.

The invention still further provides a pressure-sensitive adhesive sheet for semiconductor wafer processing, which comprises a substrate and a pressure-sensitive adhesive layer disposed on the substrate, the pressure-sensitive adhesive sheet having a stress per unit area immediately after 2% elongation of 4.5 N/20 mm$^2$ or lower in a tensile test.

The invention furthermore provides a pressure-sensitive adhesive sheet for semiconductor water processing, which comprises a substrate and a pressure-sensitive adhesive layer disposed on the substrate, the pressure-sensitive adhesive sheet having a degree of elongation of 2% or lower in a silicon wafer application test of the pressure-sensitive adhesive sheet.

The substrate preferably is a laminate composed of two or more layers made of different materials. The laminate preferably includes two layers which each are made of a polyolefin resin and have different thermal shrinkage ratios.

The pressure-sensitive adhesive sheets for semiconductor wafer processing according to the invention are suitable for use as a surface protective sheet in the back-side grinding of a semiconductor wafer.

According to the pressure-sensitive adhesive sheets for semiconductor wafer processing of the invention, the back side of a semiconductor wafer can be ground to an extremely small thickness without bending the wafer. In addition, the pressure-sensitive adhesive sheets for semiconductor wafer processing of the invention can be easily produced at low cost. When any of the pressure-sensitive adhesive sheets is used in grinding a large-diameter wafer to an extremely small thickness, the operation can be conducted without bending the wafer. Consequently, use of the pressure-sensitive adhesive sheets for semiconductor wafer processing of the invention improves productivity in conducting back-side grinding of the semiconductor wafer.

In one of the pressure-sensitive adhesive sheets for semiconductor wafer processing of the invention, the pressure-sensitive adhesive sheet or the substrate has a thermal shrinkage ratio of 2% or lower, preferably 1.5% or lower, and more preferably 1.0% or lower, after having been allowed to stand at 60°C for 10 minutes. When the thermal shrinkage ratio of the pressure-sensitive adhesive sheet or substrate is within that range and this pressure-sensitive adhesive sheet is used as a back grinding sheet in, e.g., the step of semiconductor wafer back-side grinding, then the internal stress (residual stress) which generates in this pressure-sensitive adhesive sheet due to the heat generated in back-side grinding or a succeeding processing step is exceedingly low. Accordingly, the pressure-sensitive adhesive sheet does not bend through the back-side grinding step and can keep the semiconductor wafer flat. The thermal shrinkage ratio is determined in the following manner. The pressure-sensitive adhesive sheet or the substrate is cut into a given size. The initial value of the machine-direction dimension A and the initial value of the transverse-direction dimension A' are precisely measured with a caliper gauge. The sample is allowed to stand in an environment at 60°C for 10 minutes. Thereafter, the machine-direction dimension after thermal shrinkage B and the transverse-direction dimension after thermal shrinkage B' are respectively measured. Using the following equations, the degree of machine-direction thermal shrinkage C and the degree of transverse-direction thermal shrinkage C' are respectively calculated. The larger one of the C and C' is defined as the thermal shrinkage ratio of the pressure-sensitive adhesive sheet or substrate.

$$C\ (\%) = (A - B)/A \times 100$$

$$C'\ (\%) = (A' - B')/A' \times 100$$

The thermal shrinkage ratio of the pressure-sensitive adhesive sheet or substrate can be regulated so as to be within that range by selecting the kinds of the substrate and pressure-sensitive adhesive and a combination thereof.

Another pressure-sensitive adhesive sheet of the invention has an excellent stress-relieving property. Specifically, this pressure-sensitive adhesive sheet, in a tensile test, has a stress relaxation ratio at 2% elongation of 20% or higher, preferably 30% or higher, and more preferably 50% or higher, at 1 minute after initiation of the elongated state. The stress relaxation ratio thereof at 2% elongation as determined at 10 minutes after initiation of the elongated state may be 25% or higher, preferably 30% or higher, and more preferably 50% or higher. When the stress relaxation ratio of the pressure-sensitive adhesive sheet is within that range, the stress relaxation ratio after application to an adherend is exceedingly low. Accordingly, even when the semiconductor wafer as an adherend is ground to a thickness of 75-150 $\mu$m or to an even smaller thickness, the pressure-sensitive adhesive sheet can hold the semiconductor wafer without bending it. The stress relaxation ratio is calculated in the following manner. A pressure-sensitive adhesive sheet sample having a given length is pulled at a rate of 200 mm/min to measure the stress K at 2% elongation and the stress L at 1 minute after elongation stopping. Then, the stress relaxation ratio is calculated as $(K - L)/K \times 100$ (%). The stress relaxation ratio of the pressure-sensitive adhesive sheet can be regulated so as to be within that range by selecting the kinds of the substrate and pressure-sensitive adhesive and a combination thereof.

Still another pressure-sensitive adhesive sheet of the invention has a stress per unit area immediately after 2% elongation of 4.5 N/mm$^2$ or lower, preferably 3.5 N/mm$^2$ or lower, and more preferably 3.0 N/mm$^2$ or lower. When the stress per unit area of the pressure-sensitive adhesive sheet immediately after the elongation is within that range, the semiconductor wafer as an adherend can be prevented from warping (bending) due to the tension resulting from the application. The stress per unit area immediately after elongation is calculated in the following manner. A pressure-sensitive adhesive sheet having a given length is cut into a width of 15 mm. This sample is pulled at room temperature and a rate of 200 mm/min by 2%, and the stress is measured immediately after this pulling. Using the stress A at 2% elongation and the overall thickness B (mm) of the pressure-sensitive adhesive sheet or substrate, the stress per unit area immediately after elongation is calculated as $A/(15 \times B)$ (N/mm$^2$). In the case where the pressure-sensitive adhesive side of the pressure-sensitive adhesive sheet is covered with a separator or the like, the measurement is performed on a sample from which the separator has been removed. The stress per unit area of the pressure-sensitive adhesive sheet immediately after 2% elongation can be regulated so as to be within that range by selecting the kinds of the substrate and pressure-sensitive adhesive and a combination thereof.

A further pressure-sensitive adhesive sheet of the invention, in a silicon wafer application test, has a degree of elongation of 2% or lower, preferably 1.5% or lower, and more preferably 1.0% or lower. This pressure-sensitive adhesive sheet of the invention, which has a degree of elongation within that range and has the property of being not elongated in application, comes to have almost no internal stress in the step of tape application. This pressure-sensitive adhesive sheet hence has an extremely low residual stress. Accordingly, even when a semiconductor wafer as an adherend is ground to an exceedingly small thickness, it does not bend (warp). The degree of elongation is determined in the following manner. The machine-direction dimension $\alpha$ and transverse-direction dimension $\alpha$' of a pressure-sensitive adhesive sheet cut into a given size are precisely measured with a caliper gauge. This pressure-sensitive adhesive sheet is applied to a 300-mm silicon wafer at a rate of 10 cm/sec with a 2-kg rubber roller without applying a tension thereto, Thereafter, the machine-direction dimension $\beta$ and transverse-direction dimension $\beta$' of the pressure-sensitive adhesive sheet applied are measured. The degree of machine-direction elongation $\gamma$ and the degree of transverse-direction elongation $\gamma$' are calculated using the following equations.

$$\gamma\ (\%) = (\beta - \alpha)/\alpha \times 100\ (\%)$$

$$\gamma'\ (\%) = (\beta' - \alpha')/\alpha' \times 100\ (\%)$$

The larger one of the value of the degree of machine-direction elongation $\gamma$ and that of the degree of transverse-direction elongation $\gamma$' is taken as the degree of elongation of the pressure-sensitive adhesive sheet. In the case where the pressure-sensitive adhesive side of the pressure-sensitive adhesive sheet is covered with a separator or the like, the measurement of dimensions before the application of the pressure-sensitive adhesive sheet is performed after the separator or the like is removed. The degree of elongation of the pressure-sensitive adhesive sheet in a silicon wafer application test can be regulated so as to be within that range by selecting the kinds of the substrate and pressure-sensitive adhesive and a combination thereof.

The occurrence of the bending (warpage) of a pressure-sensitive adhesive sheet used in the step of semiconductor wafer back-side grinding is closely related with the thermal shrinkage ratio, stress relaxation ratio after elongation, stress per unit area in elongation, and degree of elongation in application as described above. Although the warpage of the pressure-sensitive adhesive sheet is considerably inhibited so long as any one of those properties is within the range shown above, it is more preferred that two or more of those properties be within the respective ranges shown above. In particular, it is important for inhibiting warpage in the step of semiconductor wafer back-side grinding that the thermal shrinkage ratio after 10-minute standing at 60°C is 2% or lower. Consequently, a pressure-sensitive adhesive sheet which has a thermal shrinkage ratio after 10-minute standing at 60°C of 2% or lower and also has a stress relaxation ratio at 2% elongation of 20% or higher at 1 minute after initiation of the elongated state, a pressure-sensitive adhesive sheet which has a thermal shrinkage ratio after 10-minute standing at 60°C of 2% or lower and also has a stress per unit area after 2% elongation of 4.5 N/20 mm$^2$, a pressure-sensitive adhesive sheet which has a thermal shrinkage ratio after 10-minute standing at 60°C of 2% or lower and also has a degree of elongation in application of 2% or lower, or the like, is suitable for use as a surface protective sheet in the back-side grinding of a semiconductor wafer. A pressure-sensitive adhesive sheet in which all of the thermal shrinkage ratio, stress relaxation ratio after elongation, stress per unit area in elongation, and degree of elongation in application to a silicon wafer are within the respective ranges is an especially preferred pressure-sensitive adhesive sheet for use as a surface protective sheet in the back-side grinding of a semiconductor wafer.

Pressure-Sensitive Adhesive

The pressure-sensitive adhesive constituting the pressure-sensitive adhesive layer of each pressure-sensitive adhesive sheet of the invention is not particularly limited so long as the pressure-sensitive adhesive sheet obtained satisfies the properties described above. It can be suitably selected from conventional pressure-sensitive adhesives such as rubber-based pressure-sensitive adhesives, acrylic pressure-sensitive adhesives, polyamide pressure-sensitive adhesives, silicone pressure-sensitive adhesives, polyester pressure-sensitive adhesives, and urethane pressure-sensitive adhesives. Among these, the acrylic pressure-sensitive adhesives containing an acrylic polymer as the base polymer are suitable for use because they are excellent in various properties including heat resistance and weatherability and can be made to have desired properties by selecting, for example, the kinds of the monomer ingredients for constituting the acrylic polymer.

The acrylic polymer as the base polymer of an acrylic pressure-sensitive adhesive is constituted from one or more alkyl esters of (meth)acrylic acid as the main monomer ingredient. As the alkyl esters of (meth)acrylic acid, use can be made of, for example, $C_{1-20}$ alkyl esters of (meth)acrylic acid, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)actylate, dodecyl (meth)acrylate, tridecyl (meth)acrylate, tetradecyl (meth)acrylate, pentadecyl (meth)acrylate, octadecyl (nneth)acrylate, nonadecyl (meth)acrylate, and eicosyl (meth)acrylate (preferably $C_{1-12}$ alkyl esters of (meth)acrylic acid, more preferably $C_{1-8}$ alkyl esters of (meth)acrylic acid). One or more alkyl esters of (naeth)acrylic acid can be selected and used.

The acrylic polymer may optionally contain units derived from one or more other monomer ingredients copolymerizable with alkyl esters of (meth)acrylic acid for the purpose of modifying cohesive force, heat resistance, crosslinking ability, etc. Examples of such monomer ingredients include carboxyl-containing monomers such as acrylic acid, methacrylic acid, carboxyethyl acrylate, carboxypentyl acrylate, itaconic acid, maleic acid, fumaric acid, and crotonic acid; hydroxyl-containing monomers such as hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfo-containing monomers such as styrenesulfonic acid, arylsulfonic acids, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; phosphate-group-containing monomers such as 2-hydroxyethyl acryloylphosphate; (N-substituted) amide monomers such as (meth)acrylamide, N,N-dimethyl(meth)acrylamide, N-butyl(meth)acrylamide, N-methylol (meth)acrylamide, and N-methylolpropane(meth)acrylamide; aminoalkyl (meth)acrylate monomers such as aminoethyl (meth)acrylate, N,N-dimethylaminoethyl (meth)acrylate, and t-butylaminoethyl (meth)acrylate; alkoxyalkyl (meth)acrylate monomers; maleimide monomers such as N-cyclohexylmaleimide, N-isopropylmaleimide, N-laurylmaleimide, and N-phenylmaleimide; itaconimide monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide monomers such as N-(meth)acryloyloxymethylenesuccinimide, N-(meth)acryloyl-6-oxyhexamethylenesuccinimide, and N-(meth) acryloyl-8-oxyoctamethylenesuccinimide; vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxamides, styrene, α-methylstyrene, and N-vinylcaprolactam; cyanoacrylate monomers such as acrylonitrile and methacrylonitrile; epoxy-group-containing acrylic monomers such as glycidyl (meth)acrylate; glycol acrylic ester monomers such as polypropylene glycol (meth)acrylate, methoxyethylene glycol (meth)acrylate, and methoxypolypropylene glycol (meth)acrylate; acrylic ester monomers having one or more heterocycles, halogen atoms, silicon atoms, or the like, such as tetrahydrofurfuryl (meth)acrylate, fluoro(meth)acrylates, and silicone (meth)acrylates; polyfunctional monomers such as hexanediol di(meth)acrylate, (poly)ethylene glycol di(meth)acrylate, polypropylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, urethane acrylates, divinylbenzene, butylene di(meth)acrylate, and hexylene di(meth) acrylate; olefin monomers such as isoprene, butadiene, and isobutylene; and vinyl ether monomers such as vinyl ether. These monomer ingredients can be used alone or in combination of two or more thereof.

An acrylic copolymer can be produced by polymerizing one or more of the alkyl esters of (meth)acrylic acid enumerated above optionally together with one or more other monomers by a conventional suitable method. The molecular weight of the acrylic copolymer is not particularly limited. For example, an acrylic copolymer having a weight-average molecular weight in the range of 100,000-2,000,000, preferably 150,000-1,000,000, more preferably 300,000-1,000,000, can be used.

The pressure-sensitive adhesive can be an energy-ray-curable pressure-sensitive adhesive obtained by adding an energy-ray-polymerizable compound to a pressure-sensitive adhesive or by employing a base polymer having energy-ray-polymerizable double bonds introduced therein. A pressure-sensitive adhesive layer constituted of the energy-ray-curable pressure-sensitive adhesive exhibits sufficient adhesive force before irradiation with an energy ray but comes to have considerably reduced adhesive force upon irradiation with an energy ray. A pressure-sensitive adhesive sheet employing this pressure-sensitive adhesive layer can be easily stripped off without imposing a stress on the adherend. Examples of the energy ray include ultraviolet and electron beams.

As the energy-ray-polymerizable compound, a compound having two or more energy-ray-polymerizable carbon-carbon double bonds in the molecule thereof can be used. Examples of such compound include polyfunctional acrylate compounds. Specific examples thereof include (meth)acrylates of linear aliphatic polyols, such as 1,4-butylene di(meth) acrylate, 1,5-pentanediol di(meth)acrylate, 1,6-hexanediol di(meth)acrylate, 1,9-nonanediol di(meth)acrylate, polyethylene glycol di(meth)acrylate, and polypropylene glycol di(meth)acrylate; (meth)acrylates of aliphatic polyols having one or more alicyclic groups, such as cyclohexanedimethanol di(meth)acrylate and tricyclodecanedimethanol diacrylate; and (meth)acrylates of branched aliphatic polyols, such as trimethylolpropane tri(meth)acrylate, pentaerythritol tri(meth) acrylate, and pentaerythritol tetra(meth)acrylate, and condensates of these (e.g., ditrimethylolpropane tetraacrylate and dipentaerythritol hexaacrylate).

As the energy-ray-polymerizable compound, a polyfunctional acrylate oligomer such as a urethane acrylate oligomer may also be used. The urethane acrylate oligomer is obtained, for example, by reacting a diisocyanate compound with a polyol compound to obtain a urethane oligomer and reacting this oligomer with an alkyl (meth)acrylate having a hydroxyl group. Examples of the diisocyanate compound include tolylene diisocyanate, diphenylmethane diisocyanate, hexamethylene diisocyanate, phenylene diisocyanate, dicyclohexylmethane diisocyanate, xylene diisocyanate, tetramethylxylene diisocyanate, naphthalene diisocyanate, and isophorone diisocyanate. Examples of the polyol compound include polyhydric alcohols such as ethylene glycol, 1,4-butanediol, 1,6-hexanediol, diethylene glycol, trimethylolpropane, dipropylene glycol, polyethylene glycol, polypropylene glycol, pentaerythritol, dipentaerythritol, and glycerol. Examples thereof further include polyester polyol compounds obtained by the condensation reaction of those polyhydric alcohols with an aliphatic dicarboxylic acid, such as adipic acid, sebacic acid, azelaic acid, or maleic acid, or with an aromatic dicarboxylic acid, such as terephthalic acid or isophthalic acid; polyether polyol compounds such as polyethylene ether glycol, polypropylene ether glycol, polytetramethylene ether glycol, and polyhexamethylene ether glycol; lactone polyol compounds such as polycaprolactone glycol, polypropiolactone glycol, and polyvalerolactone glycol; and polycarbonate polyol compounds obtained by the alcohol-eliminating reaction of a polyhydric alcohol, such as ethylene glycol, propylene glycol, butanediol, pentanediol, octanediol, or nonanediol, with diethylene carbonate, dipropylene carbonate, or the like. Examples of the hydroxyl-containing alkyl (meth)acrylate compound include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethyleyelohexyl)methyl (meth)acrylate.

In the case of using an energy-ray-polymerizable compound, the amount thereof can be selected from the range of, for example, 5-200 parts by weight, preferably 10-100 parts by weight, and more preferably 10-45 parts by weight, with respect to 100 parts by weight of the base polymer.

In the case where the energy-ray-polymerizable compound used is, for example, one in which five or more reaction sites are present on the average per molecule, this results in an increased coefficient of volume expansion. There are hence cases where the pressure-sensitive adhesive sheet has an increased thermal shrinkage ratio or the pressure-sensitive adhesive shrinks upon energy ray irradiation to warp the pressure-sensitive adhesive sheet.

In the case where energy-ray-polymerizable double bonds are introduced into a base polymer in order to impart energy ray curability to a pressure-sensitive adhesive, this can be attained by copolymerizing a copolymerizable monomer having a reactive functional group, such as a carboxyl, hydroxyl, or amino group, in producing, for example, an acrylic polymer as a base polymer to thereby introduce functional groups serving as reaction sites into the base polymer and combining a polyfunctional monomer or oligomer having an energy-ray-polymerizable carbon-carbon double bond with the polymer through the functional groups serving as reaction sites. Thus, a base polymer having energy-ray-polymerizable carbon-carbon double bonds in side chains thereof can be obtained.

The energy-ray-curable pressure-sensitive adhesive may optionally contain a photopolymerization initiator. Upon irradiation with energy rays, a photopolymerization initiator is excited and activated to generate radicals and thereby accelerates the efficient polymerization/curing reaction of the pressure-sensitive adhesive layer. Examples of the photopolymerization initiator include benzoin alkyl ether initiators such as benzoin methyl ether, benzoin ethyl ether, benzoin isopropyl ether, and benzoin isobutyl ether; benzophenone initiators such as benzophenone, benzoylbenzoic acid, 3,3'-dimethyl-4-methoxybenzophenone, and polyvinylbenzophenone; aromatic ketone initiators such as $\alpha$-hydroxycyclohexyl phenyl ketone, 4-(2-hydroxyethoxy)phenyl 2-hydroxy-2-propyl ketone, $\alpha$-hydroxy-$\alpha,\alpha$'-dimethylacetophenone, methoxyacetophenone, 2,2-dimethoxy-2-phenylacetophenone, and 2,2-diethoxyacetophenone; aromatic ketal initiators such as benzyl dimethyl ketal; thioxanthone initiators such as thioxanthone, 2-chlorothioxanthone, 2-methylthioxanthone, 2-ethylthioxanthone, 2-isopropylthioxanthone, 2-dodecylthioxanthone, 2,4-dichlorothioxanthone, 2,4-dimethylthioxanthone, 2,4-diethylthioxanthone, and 2,4-diisopropylthioxanthone; benzil initiators such as benzil; and benzoin initiators such as benzoin. Examples thereof further include $\alpha$-ketol compounds (e.g., 2-methyl-2-hydmxypropiophenone), aromatic sulfonyl chloride compounds (e.g., 2-naphthalenesulfonyl chloride), optically active oxime compounds (e.g., 1-phenyl-1,1-propanedione-2-(o-ethoxycarbonyl) oxime), camphorquinone, halogenated ketones, acylphosphinoxides, and acylphosphonates. Such photopolymerization initiators can be used alone or in combination of two or more thereof.

The pressure-sensitive adhesive may be a hydrophilic pressure-sensitive adhesive obtained by employing as a base polymer a polymer having acid groups such as carboxyl groups and adding a neutralizer thereto to neutralize all or part of the acid groups in the base polymer and thereby impart hydrophilicity to the polymer. A hydrophilic pressure-sensitive adhesive generally is less apt to leave an adhesive residue on adherends and even when it has left an adhesive residue, this residue can be easily removed by washing with pure water. The polymer having acid groups may be obtained by copolymerizing a monomer having an acid group, such as the carboxyl-containing monomers enumerated above, in producing a base polymer. As the neutralizer, use may be made of, for example, a primary amine such as monoethylamine or monoethanol amine, a secondary amine such as diethylamine or diethanolamine, a tertiary amine such as triethylamine, triethanolamine, N,N,N'-trimethylethylenediamine, N-methyldiethanolamine, or N,N-diethylhydroxylamine, or an organic amino compound having alkalinity.

The pressure-sensitive adhesive may optionally contain a crosslinking agent. As the crosslinking agent, use may be made of, for example, an epoxy crosslinking agent, isocyanate crosslinking agent, melamine crosslinking agent, peroxide crosslinking agent, metal alkoxide crosslinking agent, metal chelate crosslinking agent, metal salt crosslinking agent, carbodiimide crosslinking agent, oxazoline crosslinking agent, aziridine crosslinking agent, amine crosslinking agent, or the like. It is preferred to use an epoxy crosslinking agent or an isocyanate crosslinking agent. Examples of the epoxy crosslinking agent include N,N,N',N'-tetraglycidyl-m-xylenediamine, diglycidylaniline, 1,3-bis(N,N-diglycidylaminomethyl)cyclohexane, 1,6-hexanediol diglycidyl ether, neopentyl glycol diglycidyl ether, ethylene glycol diglycidyl ether, propylene glycol diglycidyl ether, polyethylene glycol diglycidyl ether, polypropylene glycol diglycidyl ether, sorbitol polyglycidyl ether, glycerol polyglycidyl ether, pentaerythritol polyglycidyl ether, polyglycerol polyglycidyl ether, sorbitan polyglycidyl ether, trimethylolpropane polyglycidyl ether, adipic acid diglycidyl ester, o-phthalic acid diglycidyl ester, triglycidyl tris(2-hydroxyethyl)isocyanurate, resorcinol diglycidyl ether, bisphenol S diglycidyl ether, and epoxy resins having two or more epoxy groups in the molecule thereof Examples of the isocyanate crosslinking agent include lower aliphatic polyisocyanates such as 1,2-ethylene diisocyanate, 1,4-butylene diisocyanate, and 1,6-hexamethylene diisocyanate; aliphatic polyisocyanates such as cyclopentylene diisocyanate, cyclohexylene diisocyanate, isophorone diisocyanate, hydrogenated tolylene diisocyanate, and hydrogenated xylene diisocyanate; and aromatic polyisocyanates such as 2,4-tolylene diisocyanate, 2,6-tolylene diisocyanate, 4,4'-diphenylmethane diisocyanate, and xylylene diisocyanate.

The pressure-sensitive adhesive layer can be formed by applying the pressure-sensitive adhesive to a substrate by an appropriate technique using a knife coater, roll coater, gravure coater, die coater, reverse-roll coater, or the like. Alternatively, use may be made of a method in which a pressure-sensitive adhesive layer is formed on an appropriate process sheet for casting, such as a film which has undergone a surface releasant treatment, and this pressure-sensitive adhesive layer is transferred to a substrate. Although the thickness of the pressure-sensitive adhesive layer is not particularly limited, it is preferably 10 $\mu$m or larger (e.g., 10-200 $\mu$m), more preferably 15 $\mu$m or larger (e.g., 15-100 $\mu$m), and especially preferably 18 $\mu$m or larger (e.g., 18-50 $\mu$m). When the thickness of the pressure-sensitive adhesive layer is within that range, the pressure-sensitive adhesive layer diminishes the stress of the substrate to improve the stress relaxation ratio of the pressure-sensitive adhesive sheet.

The modulus of elasticity of the pressure-sensitive adhesive layer is preferably in the range of $1.0 \times 10^4$ to $1.0 \times 10^7$. Moduli of elasticity thereof outside this range are undesirable because there are cases where such a pressure-sensitive adhesive layer does not have pressure-sensitive adhesive properties which make the adhesive layer suitable for use in pressure-sensitive adhesive sheets for the back-side grinding of semiconductor wafers. In the case where an energy-ray-curable pressure-sensitive adhesive is used as the pressure-sensitive adhesive, that modulus of elasticity means the modulus of elasticity of the pressure-sensitive adhesive layer which has not been cured (before irradiation with energy rays).

Substrate

A substrate can be suitably selected and used so that the respective values of the thermal shrinkage ratio, stress relaxation ratio, stress per unit area, and degree of elongation in application as described above are in the respective desired ranges. Although the substrate is not particularly limited, a film made of a resin (plastic) can, for example, be used. The resin constituting the resinous film is not particularly limited, and may be a cured resin (e.g., a thermoset resin or photocured resin) or a thermoplastic resin. Examples thereof include the following polymers: polyolefins such as low-density polyethylene, linear polyethylene, medium-density polyethylene, high-density polyethylene, ultralow-density polyethylene, propylene random copolymers, propylene block copolymers, propylene homopolymer, polybutene, and polymethylpentene, ethylene/vinyl acetate copolymers, ionomer resins, ethylene/(meth)acrylic acid copolymers, ethylene/(meth)acrylic ester (random or alternating) copolymers, ethylene/butene copolymers, ethylene/hexene copolymers, polyurethanes, polyesters such as poly(ethylene terephthalate) and poly(ethylene naphthalate), (meth)acrylic polymers, polystyrene, polycarbonates, polyimides, polyamides, poly(amide-imide)s, polyetherimides, polysulfones, polyethersulfones, poly(vinyl chloride), poly(vinylidene chloride), fluororesins, cellulosic resins, and polymers obtained by crosslinking these polymers. A blend of two or more of these resins can be used according to need. Those resins may optionally contain additives such as an inorganic filler such as calcium carbonate, silica, or mica, a metallic filler such as iron or lead, and a colorant such as a pigment or dye. From the standpoint of improving the stress relaxation ratio of the pressure-sensitive adhesive sheet, the material to be used for constituting the substrate preferably is a resin having high stress-relieving properties, such as a thermoplastic elastomer. The substrate may be a single-layer film or may be a laminate (multilayered film) which takes advantage of merits of each resin.

Examples of the laminate include a laminated film containing a core layer and a surface layer disposed on at least one side of the core layer, Preferably, the surface layer has been disposed on each side of the core layer, and the laminated film has a three-layer structure composed of a surface layer, a core layer and the other surface layer laminated in this order. The materials to be used for constituting the core layer and the surface layers preferably are ones selected, for example, from polyolefin resins such as low-density polyethylene, linear polyethylene, medium-density polyethylene, high-density polyethylene, ultralow-density polyethylene, propylene random copolymers, propylene block copolymers, propylene homopolymer, polybutene, polymethylpentene, ethylene/vinyl acetate copolymers, ionomer resins, ethylene/ (meth)acrylic acid copolymers, ethylene/(meth)acrylic ester (random or alternating) copolymers, ethylene/butene copolymers, and ethylene/hexene copolymers and polymers obtained by irradiating such polyolefin resins with electron beams or $\gamma$-rays in a dose of 1-80 Mrad. It is preferred that the materials respectively constituting the core layer and the surface layers be selected from those polyolefin resins so that the layers differ in the thermal shrinkage ratio and interfere with each other to thereby reduce the overall thermal shrinkage ratio of the substrate. Examples of such combinations include a combination of a polyethylene and a polypropylene. Especially preferred is a combination of a crystalline polyethylene and a noncrystalline polypropylene. When a laminate including a polyethylene and a polypropylene is to be used as a substrate, it is preferred from the standpoint of anchoring properties that a layer of the polyethylene be disposed on the side of the substrate which comes into contact with the pressure-sensitive adhesive layer. In the case where the laminate has a constitution including surface layers respectively disposed on both sides of the core layer, it is preferred that the two surface layers be constituted of the same kind of material.

The ratio between the thicknesses of the layers constituting the laminate is not particularly limited. However, it is preferred that the thickness of the core layer be larger than the thickness of each surface layer. The ratio of thickness of one surface layer to thickness of the core layer can be selected, for example, from the range of from 1:12 to 3:5, preferably from the range of from 1:10 to 3:10. In the case where the laminate includes two surface layers respectively disposed on both sides of the core layer, the thickness of one surface layer and that of the other surface layer may be the same or different. Although the ratio of the thickness of one surface layer to the thickness of the other surface layer can be selected from the range of, for example, from 1:1 to 1:5, it is preferred that the two surface layers have the same thickness. Especially preferred of such laminates is a multilayered film in which the thickness ratio of (surface layer): (core layer):(surface layer) is 2:9:2. An appropriate interlayer may optionally be disposed between the core layer and each surface layer. Examples of the interlayer include an adhesive layer or undercoat layer for improving adhesion between the layers.

Methods for forming the substrate are not particularly limited. Examples thereof include a method in which a resin in a pellet form is melted and formed into a film with an extrusion film-forming machine; and a method in which a film is formed by extrusion molding with a T-die or inflation or by calendering. The thermal shrinkage ratio of the substrate depends considerably on temperature conditions in the step of film formation. For regulating the thermal shrinkage ratio of the pressure-sensitive adhesive sheet or substrate to 2% or lower, it is desirable to select a substrate produced through a film formation step not including stretching. The upper side of the substrate, i.e., the side on which a pressure-sensitive adhesive layer is to be formed, may have undergone a chemical or physical oxidation treatment such as a corona treatment, chromate treatment, ozone exposure, flame exposure, exposure to a high-tension electric shock, treatment with an ionizing radiation, or the like so as to have improved adhesion to the pressure-sensitive adhesive.

The thickness of the substrate can be selected from the range of, for example, 30-1,000 $\mu$m, preferably 40-800 $\mu$m, more preferably 50-500 $\mu$m, and especially preferably 100-200 $\mu$m. A suitable thickness can be selected so that the substrate or pressure-sensitive adhesive sheet has the properties within the ranges shown above.

As described above, the pressure-sensitive adhesive sheets for semiconductor wafer processing of the invention each have a substrate and a pressure-sensitive adhesive layer formed thereon. The pressure-sensitive adhesive layer may be protected with an appropriate separator according to the necessity. The pressure-sensitive adhesive sheets for semiconductor wafer processing each may be in the form of a roll or in a sheet form. They may be in a sheet or tape form or the like.

The pressure-sensitive adhesive sheets of the invention thus obtained can be used as, e.g., a surface protective sheet for various adherends such as electronic parts, and applications thereof are not particularly limited. The pressure-sensitive adhesive sheets of the invention are less apt to warp and can retain a flat state after application to adherends. The pressure-sensitive adhesive sheets can hence be advantageously used as surface protective sheets in the storage, conveyance, or processing of adherends which are apt to bend or break even with a slight force, such as ultrathin semiconductor wafers. The adhesive sheets are suitable also for protection in the mirror polishing of silicon wafers. Furthermore, they can be advantageously used as pressure-sensitive adhesive sheets for processing in semiconductor wafer processing steps. In particular, the adhesive sheets are suitable for use as a protective pressure-sensitive adhesive sheet (back grinding sheet) for protecting the circuit surface of a semiconductor wafer when the semiconductor wafer is polished to an extremely small thickness.

In the step of grinding the back side of a semiconductor wafer, the pressure-sensitive adhesive layer of a pressure-sensitive adhesive sheet for semiconductor wafer processing of the invention is first applied to the wafer surface (circuit pattern surface). This application step is conducted with an apparatus called a laminator in such a manner that a tension is imposed on the adhesive sheet as less as possible. However, it is substantially impossible to apply the adhesive sheet while imposing completely no tension. Accordingly, when conventional pressure-sensitive adhesive sheets heretofore in use are applied, a tension accumulates as a residual stress in the pressure-sensitive adhesive sheets to warp or break the semiconductor wafer. In contrast, the pressure-sensitive adhesive sheet for semiconductor wafer processing of the invention has a low degree of elongation in application and, hence, comes to have a reduced internal stress.

Subsequently, the back side of the wafer is ground with a grinder or the like until the wafer thickness is reduced to a given value (e.g., 50-200 $\mu$m). According to the necessity, chemical grinding by, e.g., etching is conducted. In this operation, the pressure-sensitive adhesive sheet for semiconductor wafer processing serves to fix the semiconductor wafer as well as to protect the front side (circuit pattern surface) of the semiconductor wafer, to thereby prevent the wafer surface from being fouled or damaged. Conventionally, there has been a problem that the ultrathin wafer as an adherend is bent (warped) by the thermal shrinkage of a pressure-sensitive adhesive sheet due to the heat generated in the step of wafer back-side grinding and in a processing step succeeding the grinding or by the residual stress accumulated in the pressure-sensitive adhesive sheet or by a synergistic effect thereof. Incidentally, the problems concerning such thermal shrinkage and warpage, in many cases, are attributable to the substrate in the pressure-sensitive adhesive sheet. According to the pressure-sensitive adhesive sheet for semiconductor wafer processing of the invention, at least one of the thermal shrinkage, stress generated by pressure-sensitive-adhesive-sheet elongation, stress-relieving property, and elongation of the pressure-sensitive adhesive sheet in application, which are causes of warpage, has been improved. Consequently, even when the wafer is ground to an exceedingly small thickness, the pressure-sensitive adhesive sheet of the invention does not bend the wafer and can keep the wafer flat. Especially when the pressure-sensitive adhesive sheet is used in grinding a large-diameter semiconductor wafer, which is apt to warp, to an exceedingly small thickness, the operation can be conducted without warpage of the wafer.

It is desirable that, after completion of the step of wafer back-side grinding, the pressure-sensitive adhesive sheet for semiconductor wafer processing be stripped off from the adherend without breaking the semiconductor wafer or leaving an adhesive residue. In the case where the pressure-sensitive adhesive layer of the pressure-sensitive adhesive sheet for semiconductor wafer processing of the invention is constituted of an energy-ray-curable pressure-sensitive adhesive, the pressure-sensitive adhesive sheet is irradiated from the back side (substrate side) with energy rays (e.g., ultraviolet or electron beams) to reduce the adhesive force of the pressure-sensitive adhesive layer, whereby the pressure-sensitive adhesive sheet can be easily stripped off without leaving an adhesive residue on the adherend or breaking the adherend.

Examples

The invention will be explained below in more detail by reference to Examples, but the invention should not be construed as being limited by the following Examples in any way.

Example 1

Ninety-seven parts by weight of butyl acrylate, 2 parts by weight of methyl methacrylate, and 3 parts by weight of acrylic acid were copolymerized in toluene by the solution polymerization method to obtain an acrylic polymer having a weight-average molecular weight of 550,000. A hundred parts by weight of this acrylic polymer was mixed with 0.3 parts by weight of an epoxy crosslinking agent (trade name "TETRAD C", manufactured by Mitsubishi Gas Chemical Co., Ltd.) to obtain a pressure-sensitive adhesive composition A. The pressure-sensitive adhesive composition A was applied to a process sheet for casting (50 μm-thick PET film manufactured by Toray Industries, Inc.) by the fountain die method in such an amount as to result in a dry thickness of 20 μm. Thus, a pressure-sensitive adhesive layer was formed.

A laminated film A having a thickness of 150 μm and including three layers of polyethylene/noncrystalline polypropylene/polyethylene was produced as a substrate by coextrusion with an extruder. In the laminated film A, the ratio of the thicknesses of the layers was: polyethylene/noncrystalline polypropylene/polyethylene = 2:9:2. The pressure-sensitive adhesive layer A was laminated to the laminated film A by transfer, and the resultant laminate was aged at 40°C for 24 hours to obtain a pressure-sensitive adhesive sheet A.

Example 2

Fifty parts by weight of ethyl acrylate, 50 parts by weight of butyl acrylate, and 5 parts by weight of acrylic acid were copolymerized in toluene to obtain an acrylic polymer having a weight-average molecular weight of 650,000. A hundred parts by weight of this acrylic polymer was mixed with 20 parts by weight of a UV-curable oligomer (trade name "UV-1700", manufactured by The Nippon Synthetic Chemical Industry Co., Ltd.), 1 part by weight of a polyisocyanate crosslinking agent (trade name "Coronate L", manufactured by Nippon Polyurethane Co., Ltd.), and 3 parts by weight of a photopolymerization initiator (trade name "Irgacure 65 1 ", manufactured by Ciba Specialty Chemicals Co.). Thus, an energy-ray-curable acrylic pressure-sensitive adhesive composition B was obtained.

A subsequent operation was conducted in the same manner as in Example 1, except that the pressure-sensitive adhesive composition B was used in place of the pressure-sensitive adhesive composition A. Thus, an energy-ray-curable pressure-sensitive adhesive sheet B was obtained.

Example 3

The same procedure as in Example 1 was conducted, except that a polyimide film having a thickness of 50 μm (trade name "200H", manufactured by Du Pont-Toray Co., Ltd.) was used as a substrate. Thus, a pressure-sensitive adhesive sheet C was obtained.

Comparative Example 1

The same procedure as in Example 1 was conducted, except that a 150 μm-thick single-layer film obtained by melting an ethylene/vinyl acetate copolymer having a vinyl acetate content of 17% by weight and then extrusion-molding the melt with an extruder was used as a substrate. Thus, a pressure-sensitive adhesive sheet D was obtained.

Comparative Example 2

The same procedure as in Example 1 was conducted, except that a 150 μm-thick single-layer film obtained by adding 3 parts by weight of poly(methyl methacrylate) (PMMA resin manufactured by Ardrich Co.) to 100 parts by weight of an acrylic resin (trade name "Parapet SA", manufactured by Kuraray Co., Ltd.), melting the resultant mixture, and extrusion-molding the melt with an extruder was used as a substrate. Thus, a pressure-sensitive adhesive sheet E was obtained.

Test Evaluation

The pressure-sensitive adhesive sheets obtained in the Examples and Comparative Examples were subjected to the following test evaluations. The results obtained are shown in Table 1.

Thermal shrinkage ratio

Each of the pressure-sensitive adhesive sheets obtained in the Examples and Comparative Examples was cut into a square shape having a side length of 200 mm. The sample length A in the direction of application of the pressure-sensitive adhesive and the sample length A' in the direction perpendicular to A were measured with a precision caliper gauge. This sample was allowed to stand in an environment at 60°C for 10 minutes. After this standing, the sample length B in the direction of application of the pressure-sensitive adhesive and the length B' in the direction perpendicular to B were measured. The values of (A - B)/A × 100 (%) and (A' - B')/A' × 100 were respectively calculated, and the larger one of these was defined as the thermal shrinkage ratio of the pressure-sensitive adhesive sheet.

Stress relaxation ratio

Each of the pressure-sensitive adhesive sheets obtained in the Examples and Comparative Examples was cut into a test piece having a width of 15 mm and a length of 30 mm. This test piece was pulled with a universal tensile tester at a rate of 200 mm/min to measure the stress K at 2% elongation and the stress L at 1 minute after elongation stopping. The stress relaxation ratio was calculated using the following equation.

$$\text{Stress relaxation ratio (\%)} = (K - L)/K$$

Stress per unit area after elongation

Each of the pressure-sensitive adhesive sheets obtained in the Examples and Comparative Examples was cut into a test piece having a width of 15 mm and a length of 300 mm. This test piece was pulled with a universal tensile tester at room temperature at a rate of 200 mm/min. Immediately after the test piece had been pulled by 2%, the resultant stress was measured. From the stress P (N) at 2% elongation and the overall thickness Q (mm) of the pressure-sensitive adhesive sheet, the stress per unit area was calculated using the following equation.

$$\text{Stress per unit area} = P/(15 \times Q)$$

Degree of elongation in application to wafer

Each of the pressure-sensitive adhesive sheets produced in the Examples and Comparative Examples was cut into a test piece having a width of 20 cm and a length of 25 cm. While the surface of the pressure-sensitive adhesive layer was kept exposed, the width $\alpha$ and length $\alpha'$ of the sample were measured with a precision caliper gauge. This sample was applied to a surface of a 300-mm silicon wafer at a rate of 10 cm/sec with a 2-kg rubber roller without applying a tension thereto. After the application, the width $\beta$ and length $\beta'$ of this sample were measured. The degree of width-direction elongation $\gamma$ and the degree of length-direction elongation $\gamma'$ were calculated using the following equations.

$$\gamma\ (\%) = (\beta - \alpha)/\alpha \times 100$$

$$\gamma'\ (\%) = (\beta' - \alpha')/\alpha' \times 100$$

The larger one of the values of $\gamma$ and $\gamma'$ was taken as the degree of elongation of the pressure-sensitive adhesive sheet in wafer application.

Wafer Warpage

Each of the pressure-sensitive adhesive sheets obtained in the Examples and Comparative Examples was applied to a silicon wafer (diameter, 200 mm; thickness, 750 $\mu$m) using a tape mounter (DR-8500-II, manufactured by Nitto Seiki Inc.). This silicon wafer was ground with a grinder (DFD-8560, manufactured by Disco Corp.) until the thickness of the silicon wafer reached 90 $\mu$m. After the grinding, the silicon wafer in the state of having the pressure-sensitive adhesive sheet adherent thereto was placed on a platen for precision inspection having first-grade flatness in accordance with JIS B 7513. This silicon wafer was examined for height from the platen as a zero-level surface with respect to 20 points. The difference between the largest value and smallest value of the height of the silicon wafer was determined as the warpage of the wafer.

Table 1

| | Example 1 | Example 2 | Example 3 | Comparative Example 1 | Comparative Example 2 |
|---|---|---|---|---|---|
| Substrate thickness ($\mu$m) | 150 | 150 | 50 | 150 | 150 |
| Thickness of pressure-sensitive adhesive layer ($\mu$m) | 20 | 20 | 20 | 20 | 20 |
| Energy-ray-curable | no | yes | no | no | no |
| Thermal shrinkage ratio (%) | 1 | 1 | 0.05 | 2.4 | 3 |
| Stress relaxation ratio after 1 minute (%) | 20 | 22 | 1 | 9 | 50 |
| Stress relaxation ratio after 10 minutes (%) | 25 | 26 | 3 | 12 | 70 |
| Stress per unit area immediately after elongation (N/mm$^2$) | 3 | 2.5 | 30 | 4 | 2.5 |
| Degree of elongation (%) | 0.3 | 0.4 | 0.02 | 0.45 | 2.0 |
| Wafer warpage (mm) | 0.5 | 0.3 | 0.8 | 3 | 4.5 |

While the present invention has been described in detail and with reference to specific embodiments thereof, it will be apparent to one skilled in the art that various changes and modifications can be made therein without departing from the scope thereof.

This application is based on Japanese patent application No. 2006-218681 filed August 10, 2006, the entire contents thereof being hereby incorporated by reference.

Further, all references cited herein are incorporated in their entireties.

**Claims**

1.   A pressure-sensitive adhesive sheet for semiconductor wafer processing, which comprises a substrate and a pressure-sensitive adhesive layer disposed on the substrate, said pressure-sensitive adhesive sheet or said substrate having a thermal shrinkage ratio of 2% or lower after having been allowed to stand at 60°C for 10 minutes.

2.   A pressure-sensitive adhesive sheet for semiconductor wafer processing, which comprises a substrate and a pressure-sensitive adhesive layer disposed on the substrate, said pressure-sensitive adhesive sheet having a stress relaxation ratio at 2% elongation of 20% or higher at 1 minute after initiation of the elongated state in a tensile test.

3.   The pressure-sensitive adhesive sheet according to claim 2, which has a stress relaxation ratio at 2% elongation of 25% or higher at 10 minutes after initiation of the elongated state in a tensile test.

4.   A pressure-sensitive adhesive sheet for semiconductor wafer processing, which comprises a substrate and a pressure-sensitive adhesive layer disposed on the substrate, said pressure-sensitive adhesive sheet having a stress per unit area immediately after 2% elongation of 4.5 N/20 mm$^2$ or lower in a tensile test.

5.   A pressure-sensitive adhesive sheet for semiconductor wafer processing, which comprises a substrate and a pressure-sensitive adhesive layer disposed on the substrate, said pressure-sensitive adhesive sheet having a degree of elongation of 2% or lower in a silicon wafer application test of the pressure-sensitive adhesive sheet.

6. The pressure-sensitive adhesive sheet according to claim 1, which has a degree of elongation of 2% or lower in a silicon wafer application test of the pressure-sensitive adhesive sheet.

7. The pressure-sensitive adhesive sheet according to claim 1, wherein the substrate is a laminate composed of two or more layers made of different materials.

8. The pressure-sensitive adhesive sheet according to claim 2, wherein the substrate is a laminate composed of two or more layers made of different materials.

9. The pressure-sensitive adhesive sheet according to claim 4, wherein the substrate is a laminate composed of two or more layers made of different materials.

10. The pressure-sensitive adhesive sheet according to claim 5, wherein the substrate is a laminate composed of two or more layers made of different materials.

11. The pressure-sensitive adhesive sheet according to claim 7, wherein the laminate comprises two layers which each are made of a polyolefin resin and have different thermal shrinkage ratios.

12. The pressure-sensitive adhesive sheet according to claim 8, wherein the laminate comprises two layers which each are made of a polyolefin resin and have different thermal shrinkage ratios.

13. The pressure-sensitive adhesive sheet according to claim 9, wherein the laminate comprises two layers which each are made of a polyolefin resin and have different thermal shrinkage ratios.

14. The pressure-sensitive adhesive sheet according to claim 10, wherein the laminate comprises two layers which each are made of a polyolefin resin and have different thermal shrinkage ratios.

15. The pressure-sensitive adhesive sheet according to claim 1, which is for use as a surface protective sheet in back-side grinding of the semiconductor wafer.

16. The pressure-sensitive adhesive sheet according to claim 2, which is for use as a surface protective sheet in back-side grinding of the semiconductor wafer.

17. The pressure-sensitive adhesive sheet according to claim 4, which is for use as a surface protective sheet in back-side grinding of the semiconductor wafer.

18. The pressure-sensitive adhesive sheet according to claim 5, which is for use as a surface protective sheet in back-side grinding of the semiconductor wafer.

**REFERENCES CITED IN THE DESCRIPTION**

**Patent documents cited in the description**

- JP 2000150432 A

- JP 2006218681 A